# EUROPEAN PATENT SPECIFICATION

(11) **EP 0 509 247 B1**
(45) Date of publication and mention of the grant of the patent: **06.11.1996**
(21) Application number: 92104417.8
(22) Date of filing: 13.03.1992
(51) Int. Cl.: H01L 31/0352, H01L 31/09

(54) **Infrared detector**
Infrarotdetektor
Détecteur infrarouge

(30) Priority: 15.03.1991 JP 50963/91
(43) Date of publication of application: 21.10.1992
(73) Proprietor: FUJITSU LIMITED, Kawasaki-shi, Kanagawa 211 (JP)
(72) Inventor: Ueda, Toshiyuki, c/o Fujitsu Limited, Kawasaki-shi, Kanagawa 211 (JP)
(74) Representative: Schmidt-Evers, Jürgen, Dipl.-Ing.

(56) References cited:
- EP-A- 0 149 178
- EP-A- 0 345 972
- US-A- 5 077 593
- APPLIED PHYSICS LETTERS. vol. 56, no. 9, 26 February 1990, NEW YORK US pages 851 - 853 LEVINE ET AL. 'HIGH SENSITIVITY LOW DARK CURRENT 10 um GaAs QUANTUM WELL INFRARED PHOTODETECTORS'

## Description

### BACKGROUND OF THE INVENTION

### Field of the Invention

The present invention relates to a photoconductive type infrared detector using a multiquantum well in which semiconductor layers whose band gaps are different from each other are alternately grown and, more particularly, to a detector which responds to far infrared rays whose wavelengths are 7 to 12 µm. With the advancement of compound semiconductor epitaxial growth technology in recent years, it has become possible to form multiquantum wells formed of GaAs type compound semiconductors, which have excellent crystal quality and whose structures and compositions are controlled satisfactorily. Infrared detectors formed from such multiquantum wells and image pickup devices with a plurality of infrared detectors arranged on a GaAs substrate have been under development.

### Description of the Related Art

An infrared detector formed from a multiquantum well has been proposed (B. F. Levine et al., Appl. Phys. Lett. Vol.53, No.4, p.296-298 July 25, 1988).

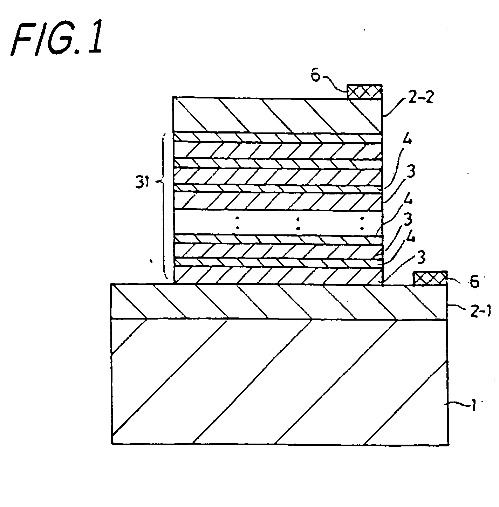

As shown in Fig. 1, the above infrared detector has a construction in which are in turn formed a contact layer 2-1, approximately 1 µm thick, composed of GaAs having an electron density (n) of n = 2x10¹⁸/cm³, a multiquantum well 31 in which approximately 50 layers of a barrier layer 3, approximately 30 nm thick, having a composition of non-doped Al_{0.31}Ga_{0.69}As, and approximately 50 layers of a well layer 4, approximately 4 nm thick, composed of GaAs having an electron density of n = 2x10¹⁸/cm³, are grown, and a contact layer 2-2, approximately 0.5 µm thick, composed of GaAs having an electron density (n) of n = 2x10¹⁸/cm³. The upper contact layer 2-2 and the multiquantum well 31 are mesa-etched to expose a part of the top surface of the lower contact layer 2-1. Thereafter, an electrode 6 made of a layer of an alloy (Au-Ge) of gold and germanium is formed on the surface of both contact layers 2-1 and 2-2.

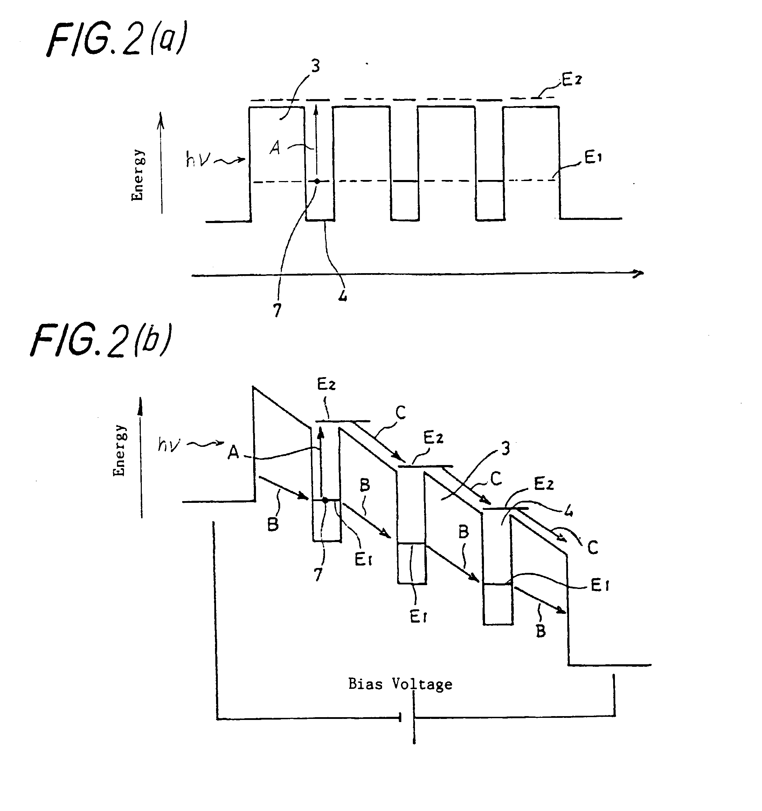

Fig. 2 shows the energy bands of the multiquantum well 31. The solid line indicates the energy level of the bottom of the conduction band. Figs. 2(a) and 2(b) show a case in which a bias voltage is not applied between the contact electrodes 2-1 and 2-2 and a case in which a bias voltage is applied between the contact electrodes 2-1 and 2-2, respectively. Reference letters E₁ and E₂ denote a ground level and a first excitation level in the conduction bands, respectively. The energy gap between these levels corresponds to 8.3 µm in terms of the wavelength of photons. Most of the electrons thermally excited into the conduction band are in the ground level E₁ in a state in which light is not incident on the multiquantum well 31. When light having a photon energy hυ (≧ E₂ - E₁) enters the multiquantum well 31, electrons in the ground level E₁ are excited to the first excitation level E₂ as indicated by arrow A. In a case where a bias voltage is applied between the contact electrodes 2-1 and 2-2, the electrons are moved in the conduction bands according to their polarity, as indicated by arrow C and detected as a photoelectric current (Iₚ).

In contrast, in a case where a bias voltage is applied between the contact electrodes 2-1 and 2-2 but light is not incident on the multiquantum well 31, the electrons 7 in the ground level E₁, which pass the forbidden band of the barrier layer 3 due to a tunnel effect, as indicated by arrow B. This tunnel current is a dark current (I_{d}) which is irrespective of whether light is incident upon the multiquantum well 31.

Generally, a signal to noise ratio (S/N) of an infrared detector is one of the factors which determine the sensitivity of the detector. A reduction of noise (N) is an important consideration for improved sensitivity. Noise in an electric current flowing through a semiconductor can be expressed as N = (2qI_{d})^{1/2} (q:electric charges of electrons). Therefore, if the dark current (I_{d}) is decreased, the noise (N) can be decreased. In an ordinary infrared detector, particularly a detector for detecting far infrared rays whose response wavelength is 7 to 12 µm, the dark current decreases by cooling the detector to a low temperature. However, as described above, the dark current (I_{d}) of the infrared detector shown in Figs. 1 and 2 is not decreased even if the detector is cooled, because the current is a tunnel current which flows through the barrier layer 3.

In the document "Applied Physics Letters", Vol. 56, No. 9, February 26, 1990, pages 851 - 853 it is suggested to decrease the tunneling dark current by increasing the barrier width of all barrier layers. However, this results, on the one hand, in a very large size of the detector and, on the other hand, in a decreased photoelectric current.

### SUMMARY OF THE INVENTION

An object of the present invention is to provide an infrared detector with low noise.

Another object of the present invention is to provide an infrared detector which has high detectivity by reducing a dark current without reducing a photoelectric current.

A further object of the present invention is to decrease noise without a substantial increase in the dimensions of an infrared detector.

According to the present invention, an infrared detector is provided, comprising a plurality of well layers and a plurality of barrier layers, each of the well layers being formed of a first semiconductor having a band gap larger than the quantum energy of an infrared ray to be detected and being disposed between adjacent two of the barrier layers, and each of the barrier layers being formed of a second semiconductor having a band gap larger than that of the first semiconductor layer, a pair of contact layers, each formed of a semiconductor whose bottom of the conduction band is lower than that of the barrier layers, the pair of contact layers being disposed so as to sandwich the well layers and the barrier layers therebetween, and a pair of electrodes for external connections, the electrodes being formed to respectively have an ohmic contact with the contact layers, wherein one of the barrier layers has a thickness larger than that of the remaining barrier layers, the larger thickness being such that the tunneling of electrons therethrough is significantly reduced and each of the well layers has a first excitation level higher than the upper end of the band gap of the second semiconductor which forms the barrier layers.

The present invention pertains to an infrared detector having a multiquantum well, in which a tunnel current which causes a dark current is suppressed by increasing the thickness of at least one barrier layer which forms the multiquantum well. As a result, noise can be reduced without a decrease in the photoelectric current or an increase in the dimensions of the detector.

The aforementioned and other objects, features and advantages of the present invention will become clear when reference is made to the following description of the preferred embodiments of the present invention, together with reference to the accompanying drawings.

### BRIEF DESCRIPTION OF THE DRAWINCS

Fig. 1 is a cross-sectional view which illustrates the construction of a conventional infrared detector using a multiquantum well;
Fig. 2 is an energy band diagram of the multiquantum well in Fig. 1; Fig. 2(a) shows a state in which a bias voltage is not applied; and Fig. 2(b) shows a state in which a bias voltage is applied;
Fig. 3 is a cross-sectional view which illustrates the construction of an infrared detector of the present invention;
Fig. 4 is an energy band diagram of the multiquantum well in Fig. 3;
Fig. 5 is a graph which illustrates an effect of the decrease in a dark current according to the present invention; and
Fig. 6 is a graph which illustrates comparison of the responsivity of the infrared detector of the present invention with that of the conventional infrared detector.

### DESCRIPTION OF THE PREFERRED EMBODIMENT

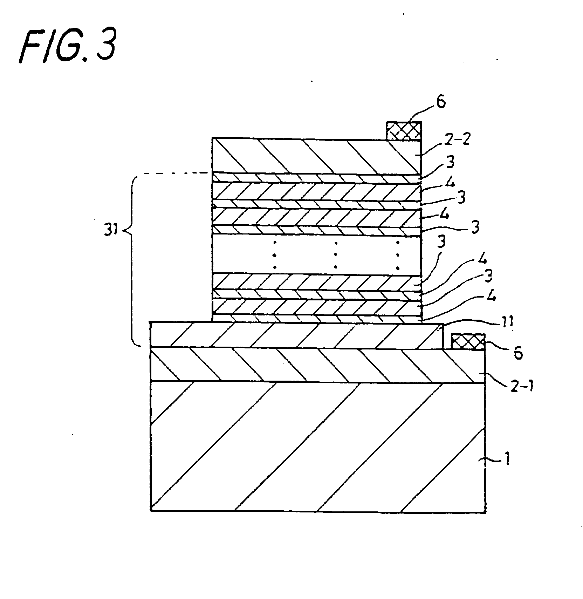

Referring to Fig. 3, a contact layer 2-1, approximately 1 µm thick, composed of GaAs having an electron density of 2x10¹⁸/cm³, is epitaxially grown on the surface of a semiinsulating GaAs substrate 1 which shows (100) surface, and further a barrier layer 11 composed of non-doped AlGaAs is epitaxially grown thereon. The growth of these layers may be performed by any one of the well-known molecule-beam epitaxy (MBE) process or a metal organic chemical vapor deposition (MOCVD) process.

Next, 50 layers of a well layer 4, 4 nm thick, composed of GaAs having an electron density of 2x10¹⁸/cm³, and 50 layers of a barrier layer 3, 30 nm thick, composed of non-doped AlGaAs, are alternately epitaxially grown, and a multiquantum well 31 is formed. The composition of the barrier layer 3 is controlled to a composition represented by Al_{0.31}Ga_{0.69}As according to the desired spectral sensitivity characteristics of the infrared detector when the peak of the sensitivity is positioned at, for example, 8.3 µm. The barrier layer 11 is controlled to be the same composition as that of the barrier layer 3. Then, a contact layer 2-2, approximately 1 µm thick, composed of GaAs having an electron density of 2x10¹⁸/cm³, is epitaxially grown. The growth of these layers may be performed by any one of either the MBE process or the MOCVD process.

Next, the contact layer 2-2 and the multiquantum well 31 are mesa-etched, as shown, by lithography using a resist mask (not shown) and an etchant in which hydrofluoric acid (HF), H₂O₂ and H₂O are mixed at a volume ratio of 1:60:5000. Furthermore, a part of the surface of the contact layer 2-1 is exposed by removing the end portion of the barrier layer 11 by an etching method similar to that described above. Thereafter, an electrode 6 made of an Au-Ge alloy is formed on each of the surface of the contact layer 2-2 and the exposed surface of the contact layer 2-1 by using a well-known vacuum deposition and a liftoff method. Furthermore, heat treatment is performed, and the infrared detector of the present invention is completed. In the above mesa etching, the barrier layer 11 may be etched at the same time.

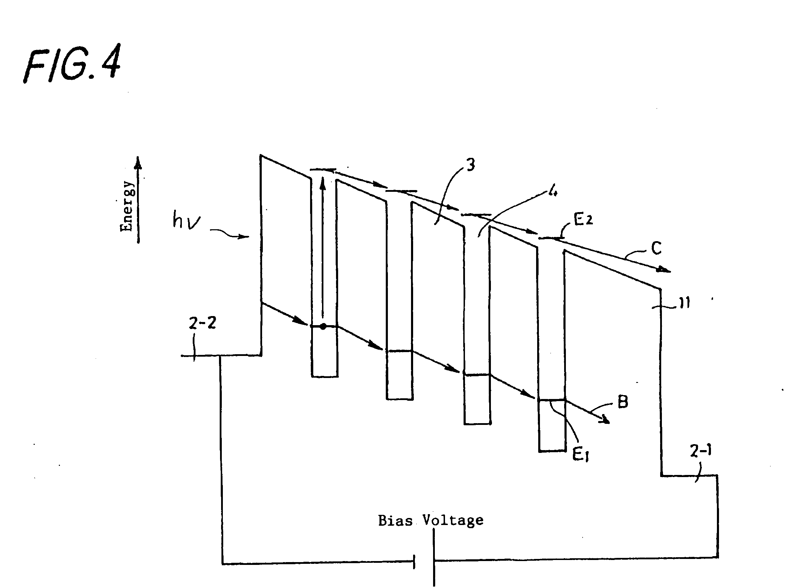

Fig. 4 is an energy band diagram of a case in which a bias voltage is applied between the electrodes 6 of the infrared detector constructed as shown in Fig. 3, with, for example, the barrier layer 11 being used as a positive polarity. A ground level and a first excitation level indicated by E₁ and E₂, respectively, are formed in the well layer 4. The ground level E₁ is positioned higher than the upper end of the band gap of the semiconductor which forms the well layer 4 and lower than the upper end of the upper end of the band gap of the semiconductor which forms the barrier layer 3. In contrast, the first excitation level E₂ is positioned higher than the upper end of the band gap of the semiconductor which forms the barrier layer 3. These levels E₁ and E₂ are determined mainly by the thickness of a well layer (e.g., the GaAs layer 4) and by the difference between the energies of the bottoms of their conduction bands of the well layer and a barrier layer (e.g., the AlGaAs layer 3). Electrons in the ground level E₁ are excited to the first excitation level E₂ by the irradiation of an infrared ray and move in the conduction band as indicated by the arrow C. Electrons which pass through the barrier layer 3 due to a tunnel effect move as indicated by the arrow B. Since these tunnel electrons are blocked by the thick barrier layer 11, the probability that they will reach the contact layer 2-1 decreases. Therefore, the dark current (I_{d}) due to the tunnel electrons are reduced. Since the photoelectric current (Iₚ) is carried by electrons which move in the conduction band as indicated by the arrow C, it is hardly affected by an increase in the thickness of the barrier layer 11.

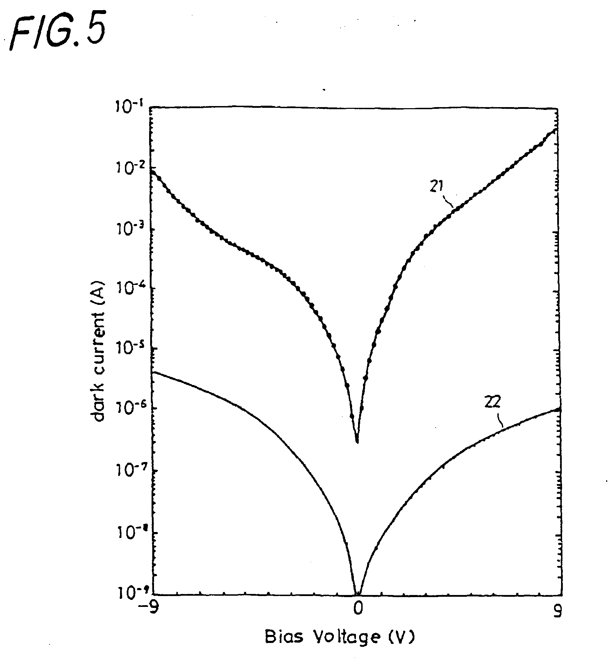

Fig. 5 is a graph which illustrates an effect of the decrease in a dark current according to the present invention. A bias voltage applied between the contact layers 2-1 and 2-2 is plotted in the horizontal axis, and the dark current (I_{d}) is plotted in the vertical axis. A curve 22 indicates the dark current characteristics of the infrared detector of the present invention. A curve 21, shown for comparison, indicates the dark current characteristics of the conventional infrared detector constructed as shown in Fig. 1 in which the thick barrier layer 11 is not provided. It becomes evident that the dark current is reduced by three orders or more by making the thickness of one barrier layer 11 twice that of the other barrier layers, as shown in Fig. 5. In addition, it can be seen that since the curve is almost symmetric from left to right, the effect is the same when the barrier layer 11 is provided in either the contact layer 2-1 side or the contact layer 2-2 side.

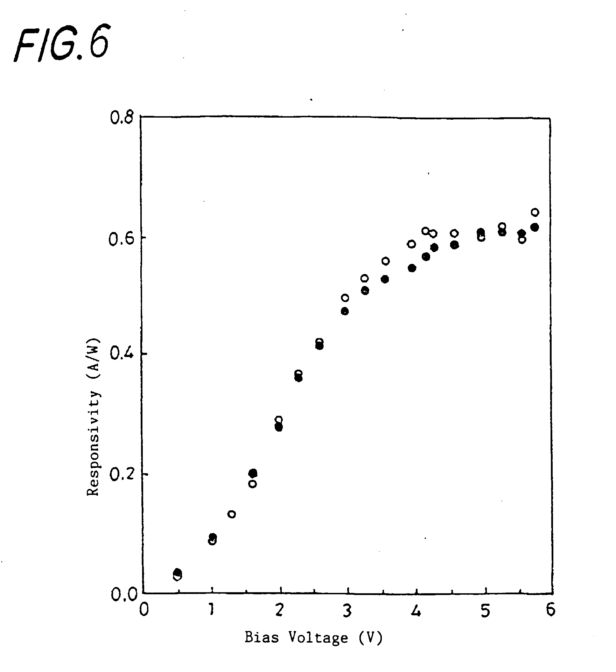

Fig. 6 is a graph which illustrates the responsivity of the infrared detector of the present invention. A bias voltage applied between the contact layers 2-1 and 2-2 is plotted in the horizontal axis, and responsivity, i.e., the photoelectric current with respect to unit incidence energy (A/W) is plotted in the vertical axis. White circles relate to the characteristics of the detector of the present invention, and the blackened circles relate to the characteristics of the conventional detector, which are shown for comparison. The light source is a blackbody radiation of 500K. As shown in Fig. 6, it can be seen that the photoelectric current hardly changes even if the thick barrier layer 11 is provided.

In the infrared detector of the present invention, as described above, the dark current (I_{d}) resulting from the tunnel electrons is reduced by making the barrier layer 11 thick. However, if all the barrier layers 3 are made thick, the following drawbacks arise: (i) the thickness of the multiquantum well 31 increases, and the infrared detector becomes larger; and (ii) the lattice scattering and recombination probability for excited electrons which pass through the barrier layer 3 will increase, and therefore the photoelectric current (Iₚ) is reduced. From the results of Figs. 5 and 6, it is sufficient that the thickness of one barrier layer be made large. It may be said that a conspicuous effect can be obtained when the size thereof is doubled. As described above, since the dark current characteristic curve hardly varies in response to the position of the barrier layer 11, it is clear that a thick barrier layer may be provided at a desired position inside the multiquantum well 31.

Although in the above-described embodiment a case in which the present invention is applied to an infrared detector having the multiquantum well 31 formed from a GaAs layer and a AlGaAs layer is shown, needless to say, the present invention can be applied to infrared detectors using the photoconduction in a multiquantum well formed of a combination of other semiconductor layers.

## Claims

1. An infrared detector, comprising:
a plurality of well layers (4) and a plurality of barrier layers (3), each of the well layers (4) being formed of a first semiconductor having a band gap larger than the quantum energy of an infrared ray to be detected and being disposed between adjacent two of the barrier layers (3), and each of the barrier layers (3) being formed of a second semiconductor having a band gap larger than that of the first semiconductor layer,
a pair of contact layers (2), each formed of a semiconductor whose bottom of the conduction band is lower than that of the barrier layers (3), the pair of contact layers (2) being disposed so as to sandwich the well layers (4) and the barrier layers (3) therebetween, and
a pair of electrodes (6) for external connections, the electrodes being formed to respectively have an ohmic contact with the contact layers (2),
**characterized in that**
one of said barrier layers (3) has a thickness larger than that of the remaining barrier layers, the larger thickness being such that the tunneling of electrons therethrough is significantly reduced, and
each of said well layers (4) has a first excitation level higher than the upper end of the band gap of said second semiconductor which forms said barrier layers (3).

2. An infrared detector according to claim 1,
**characterized in that**
each of said well layers (4) has a ground level higher than the upper end of the band gap of said first semiconductor which forms said well layers (4) and lower than the upper end of the band gap of said second semiconductor which forms said barrier layers (3).

## Patentansprüche

1. Infrarotdetektor, umfassend
eine Vielzahl von Potentialtopfschichten (4) und eine Vielzahl von Sperrschichten (3), wobei jede der Potentialtopfschichten (4) aus einem ersten Halbleiter mit einem größeren Bandabstand als die Quantenenergie einer zu erfassenden Infrarotstrahlung gefertigt und zwischen zwei benachbarten Sperrschichten (3) angeordnet ist, und wobei jede der Sperrschichten (3) aus einem zweiten Halbleiter mit einem größeren Bandabstand als der erste Halbleiter gefertigt ist,
ein Paar von Kontaktschichten (2), die jeweils aus einem Halbleiter gefertigt sind, dessen Leitungsbandunterkante niedriger als die der Sperrschichten (3) ist, und die derart angeordnet sind, daß zwischen ihnen die Potentialtopfschichten (4) und die Sperrschichten (3) eingeschlossen sind, und
ein Paar von Elektroden (6) für externe Verbindungen, die einen ohmschen Kontakt mit den Kontaktschichten (2) aufweisen,
**dadurch gekennzeichnet,**
daß eine der Sperrschichten (3) eine größere Dicke als die verbleibenden Sperrschichten aufweist, wobei die größere Dicke derart ist, daß das Durchtunneln der Elektronen durch die entsprechende Sperrschicht deutlich reduziert ist, und
daß jede der Potentialtopfschichten (4) ein erstes Anregungsniveau aufweist, welches höher als das obere Ende des Bandabstands des die Sperrschichten (3) bildenden zweiten Halbleiters ist.

2. Infrarotdetektor nach Anspruch 1,
**dadurch gekennzeichnet,**
daß jede der Potentialtopfschichten (4) ein Grundniveau aufweist, welches höher als das obere Ende des Bandabstandes des die Potentialtopfschichten (4) bildenden ersten Halbleiters und niedriger als das obere Ende des Bandabstandes des die Sperrschichten (3) bildenden zweiten Halbleiters ist.

## Revendications

1. Détecteur infrarouge comprenant :
une pluralité de couches de puits (4) et une pluralité de couches de barrière (3), chacune des couches de puits (4) étant formée en un premier semiconducteur présentant une bande interdite supérieure à l'énergie quantique d'un rayon infrarouge à détecter et étant disposée entre deux couches adjacentes prises parmi les couches de barrière (3) et chacune des couches de barrière (3) étant formée en un second semiconducteur présentant une bande interdite supérieure à celle de la première couche semiconductrice,
une paire de couches de contact (2) dont chacune est formée en un semiconducteur dont le fond de la bande de conduction est inférieur à celui des couches de barrière (3), la paire de couches de contact (2) étant disposée de manière à prendre en sandwich les couches de puits (4) et les couches de barrière (3) entre ; et
une paire d'électrodes (6) pour des connexions externes, les électrodes étant formées de manière à présenter respectivement un contact ohmique avec les couches de contact (2),
caractérisé en ce que :
l'une desdites couches de barrière (3) présente une épaisseur supérieure à celle des couches de barrière restantes, l'épaisseur plus importante étant telle que l'effet tunnel d'électrons au travers est réduit significativement ; et
chacune desdites couches de puits (4) présente un premier niveau d'excitation supérieur à l'extrémité supérieure de la bande interdite dudit second semiconducteur qui forme lesdites couches de barrière (3).

2. Détecteur infrarouge selon la revendication 1, caractérisé en ce que chacune desdites couches de puits (4) présente un niveau de masse supérieur à l'extrémité supérieure de la bande interdite dudit premier semiconducteur qui forme lesdites couches de puits (4) et inférieur à l'extrémité supérieure de la bande interdite dudit second semiconducteur qui forme lesdites couches de barrière (3).
